# EUROPÄISCHE PATENTANMELDUNG

(11) **EP 4 372 803 A1**
(43) Veröffentlichungstag der Anmeldung: **22.05.2024**
(21) Anmeldenummer: 23204829.8
(22) Anmeldetag: 20.10.2023
(51) Int. Cl.: H01L 23/31, H01L 21/56, H01L 21/48, H01L 23/538, H01L 23/373

(54) **ELEKTRISCHES MODUL UND VERFAHREN ZUR HERSTELLUNG EINES ELEKTRISCHEN MODULS**

(30) Priorität: 28.10.2022 DE 102022128625
(71) Anmelder: Rolls-Royce Deutschland Ltd & Co KG, 15827 Blankenfelde-Mahlow (DE)
(72) Erfinder: WALTRICH, Uwe, 15827 Blankenfelde-Mahlow (DE); BUCHERT, Stanley, 15827 Blankenfelde-Mahlow (DE)

(57) **Zusammenfassung**

Die Erfindung betrifft ein elektrisches Modul (1), das aufweist: einen keramischen Schaltungsträger (2), ein elektrisches Bauelement (3), das auf dem keramischen Schaltungsträger (2) angeordnet ist, ein Substrat, in dem der keramische Schaltungsträger (2) und das elektrische Bauelement (3) angeordnet sind, wobei das Substrat durch ein Vergussmaterial (6) gebildet ist, und eine Oberseite (11) des elektrischen Moduls (1), die elektrische Kontaktflächen (713, 723, 733) ausbildet. Es ist vorgesehen, dass das elektrische Modul (1) gestufte Metallstrukturen (72, 73) umfasst, die an der Oberseite (11) des elektrischen Moduls (1) angeordnet sind, wobei jede Metallstruktur (72, 73) Bereiche (723, 724; 733, 734) unterschiedlicher Dicke (d1, d2) aufweist, und wobei die Metallstrukturen (72, 73) an ihrer Oberseite (721, 731) jeweils eine der elektrischen Kontaktflächen (723, 733) des elektrischen Moduls (1) ausbilden und an ihrer Unterseite (722, 732) in einem Bereich (724, 734) erhöhter Dicke jeweils einen der elektrischen Kontakte (33, 34) auf der Oberseite (31) des elektrischen Bauelements (3) kontaktieren. Die Erfindung betrifft des Weiteren ein Verfahren zur Herstellung eines solchen elektrischen Moduls.

## Beschreibung

Die Erfindung betrifft ein elektrisches Modul gemäß dem Oberbegriff des Patentanspruchs 1 und ein Verfahren zur Herstellung eines solchen elektrischen Moduls.

Es ist bekannt, einen einzelnen Leistungshalbleiter in einem elektrisch zur Umgebung isolierten elektrischen Modul, auch als Prepackage-Modul bezeichnet, anzuordnen, das über an seiner Oberseite ausgebildete Modulkontakte mit einer Hauptplatine verbindbar ist. Innerhalb eines solchen Prepackage-Moduls ist der Leistungshalbleiter auf einem keramische Schaltungsträger angeordnet, der eine Keramikschicht und eine darauf angeordnete Metallisierungsschicht auf Hochvoltpotential ausbildet und direkt oder über weitere Schichten mit einem Kühlkörper gekoppelt ist. Ein Beispiel für einen derartigen keramischen Schaltungsträger sind sogenannte DBC-Substrate (DBC = "Direct Bonded Copper"). Derartige keramische Schaltungsträger dienen der elektrischen Isolation des auf dem keramischen Schaltungsträger angeordneten Leistungshalbleiters zum Kühlkörper und gleichzeitig der thermischen Anbindung an den Kühlkörper.

Das Volumen von Prepackage-Modulen der genannten Art ist durch ein Vergussmaterial ausgefüllt und elektrisch isoliert. Das Vergussmaterial muss dabei blasenfrei im gesamten Volumen appliziert werden, um einerseits die Luft- und Kriechstreckenanforderungen zu erfüllen und andererseits das Auftreten von Teilentladungen zu verhindern. Die aus Sicht der Isolationsanforderungen kritische Stelle stellt dabei die Oberseite des Leistungshalbleiters dar. Damit das Vergussmaterial zuverlässig und blasenfrei in den Spalt zwischen der Oberseite des Leistungshalbleiters und der Oberseite des Prepackage-Moduls appliziert werden kann, sind möglichst große Spalthöhen anzustreben. Allgemein ist anzustreben, dass die oberseitige Geometrie des Prepackage-Moduls flexibel an die Anforderungen des Vergussprozesses anpassbar ist.

Der vorliegenden Erfindung liegt die Aufgabe zugrunde, ein elektrisches Modul bereitzustellen, das die Einhaltung der erforderlichen Luft- und Kriechstreckenanforderungen durch ein flexibles Design der oberseitigen Modulgeometrie ermöglicht. Des Weiteren soll ein Verfahren zur Herstellung eines solchen elektrischen Moduls bereitgestellt werden.

Diese Aufgabe wird durch ein elektrisches Modul mit den Merkmalen des Anspruchs 1 und ein Verfahren mit den Merkmalen des Anspruchs 10 gelöst. Ausgestaltungen der Erfindung sind in den abhängigen Ansprüchen angegeben.

Danach betrachtet die Erfindung ein elektrisches Modul, das einen keramischen Schaltungsträger und ein elektrisches Bauelement aufweist, das auf dem keramischen Schaltungsträger angeordnet ist. Dabei umfasst das elektrische Bauelement eine Oberseite und eine Unterseite, ist mit seiner Unterseite auf dem keramischen Schaltungsträger angeordnet und bildet auf seiner Oberseite elektrische Kontakte aus. Der keramische Schaltungsträger und das elektrische Bauelement sind in einem Substrat angeordnet, das durch ein Vergussmaterial gebildet ist. Eine Oberseite des elektrischen Moduls bildet elektrische Kontaktflächen aus.

Es ist vorgesehen, dass das elektrische Modul gestufte Metallstrukturen umfasst, die an der Oberseite des elektrischen Moduls angeordnet sind, wobei jede Metallstruktur Bereiche unterschiedlicher Dicke aufweist, und wobei die Metallstrukturen
- an ihrer Oberseite jeweils eine der elektrischen Kontaktflächen des elektrischen Moduls ausbilden, und
- an ihrer Unterseite in einem Bereich erhöhter Dicke jeweils einen der elektrischen Kontakte auf der Oberseite des elektrischen Bauelements kontaktieren.

Die erfindungsgemäße Lösung beruht auf dem Gedanken, zur Kontaktierung von elektrischen Kontaktflächen auf der Oberseite des elektrischen Bauelements gestufte Metallstrukturen einzusetzen, die Bereiche mit unterschiedlicher Dicke aufweisen, wobei ein Bereich erhöhter Dicke, der das elektrische Bauelement kontaktiert, entsprechend den Anforderungen an den Vergussprozess flexibel in seiner Höhe eingestellt werden kann. Insbesondere kann über die Höhe des Bereichs erhöhter Dicke der Spalt zwischen dem elektrischen Bauelement (bei dem es sich beispielsweise um einen Leistungshalbleiter handelt) und der Oberseite des elektrischen Moduls eingestellt werden, so dass dieser angepasst an die Anforderungen des Vergussprozesses zuverlässig und blasenfrei mit dem Vergussmaterial gefüllt werden kann. Damit ist es möglich, die Luft- und Kriechstreckenanforderungen zuverlässig zu erfüllen.

Ein weiterer, mit der erfindungsgemäßen Lösung verbundener Vorteil besteht darin, dass eine erhöhte Flexibilität des Designs des elektrischen Moduls bei Anpassung oder Änderung der Chipgeometrie des elektrischen Bauelements möglich ist. Auch sind verbesserte Toleranzketten erzielbar.

Es wird darauf hingewiesen, dass im Sinne der vorliegenden Erfindung diejenige Seite des elektrischen Moduls, die die elektrischen Kontaktflächen ausbildet, als Oberseite des elektrischen Moduls bezeichnet wird. Die Unterseite des elektrischen Moduls ist die Seite, die thermisch an einen Kühlkörper koppelbar ist.

Ein Vergussmaterial im Sinne der vorliegenden Erfindung ist insbesondere jedes Material, das spritzgussfähig oder spritzpressfähig ist. Beispiele sind Duroplaste und Elastomere, beispielsweise Epoxidharze. Eine Epoxid-Vergussmasse zeichnet sich durch eine hohe Steifigkeit und Zugfestigkeit, eine hohe Temperaturbeständigkeit und eine geringe Schrumpfung aus. Auch besitzt sie eine hohe elektrische Durchschlagsfestigkeit.

Eine Ausgestaltung der Erfindung sieht vor, dass der keramische Schaltungsträger eine isolierende Keramikschicht und eine auf der Oberseite der Keramikschicht angeordnete erste Metallisierungsschicht aufweist, wobei das elektrische Bauelement auf der Oberseite der ersten Metallisierungsschicht angeordnet und elektrisch mit dieser verbunden ist. Zusätzlich kann auf der Unterseite der Keramikschicht eine weitere Metallisierungsschicht vorgesehen sein. Ein solcher keramischer Schaltungsträger ermöglicht eine elektrische Isolation des auf dem keramischen Schaltungsträger angeordneten elektrischen Bauelements zu einem metallischen Kühlkörper, auf dem der keramische Schaltungsträger zur Kühlung angeordnet wird. Gleichzeitig erlaubt er eine gute thermischen Anbindung an einen solchen Kühlkörper.

Eine weitere Ausgestaltung sieht vor, dass das elektrische Modul eine weitere gestufte Metallstruktur aufweist, die an ihrer Oberseite eine der elektrischen Kontaktflächen des elektrischen Moduls ausbildet und die an ihrer Unterseite in einem Bereich erhöhter Dicke die erste Metallisierungsschicht des keramischen Schaltungsträgers oder einen auf dieser angeordneten Abstandhalter kontaktiert. Dabei kann vorgesehen sein, das die weitere gestufte Metallstruktur die erste Metallisierungsschicht direkt kontaktiert und dazu einen Bereich erhöhter Dicke aufweist, der höher ausgebildet ist als der Bereich erhöhter Dicke der anderen Metallstrukturen.

Hintergrund dieser Ausgestaltung ist der Umstand, dass das Unterseitenpotential des elektrischen Bauelements über die auf der Keramikschicht angeordnete erste Metallisierungsschicht bereitgestellt wird. Zu Kontaktierung der Metallisierungsschicht wird eine weitere gestufte Metallstruktur eingesetzt. Nun ist der Abstand zwischen der Oberseite des elektrischen Moduls und der Metallisierungsschicht um die Dicke des elektrischen Bauelements größer als der Abstand zwischen der Oberseite des elektrischen Moduls und der Oberseite des elektrischen Bauelements, auf der dessen Oberseitenkontakte ausgebildet sind. Um diesen größeren Abstand zu kompensieren, sieht eine Ausgestaltung der Erfindung vor, eine gestufte Metallstruktur einzusetzen, die einen Bereich erhöhter Dicke aufweist, der höher ausgebildet ist als der Bereich erhöhter Dicke der anderen Metallstrukturen. Auf diese Weise kann die im Modul tiefer liegende erste Metallisierungsschicht durch die weitere gestufte Metallstruktur direkt kontaktiert werden. Alternativ kann vorgesehen sein, dass auf der ersten Metallisierungsschicht zusätzlich ein leitendes Abstandselement angeordnet ist. In diesem Fall kann die weitere gestufte Metallstruktur in gleicher Weise ausgebildet sein wie die anderen gestuften Metallstrukturen.

Eine weitere Ausgestaltung sieht vor, dass das elektrische Modul insgesamt drei Metallstrukturen umfasst, die drei elektrische Kontaktflächen des elektrischen Moduls ausbilden, wobei zwei der Metallstrukturen die Oberseite des elektrischen Bauelements zur Bereitstellung eines Gate-Potentials und eines Source-Potentials kontaktieren und eine der Metallstrukturen die erste Metallisierungsschicht zur Bereitstellung eines Drain-Potentials kontaktiert (wobei die erste Metallisierungsschicht das Unterseitenpotential des elektrischen Bauelements bereitstellt). Dabei handelt es sich bei dem in das elektrische Modul integrierten elektrischen Bauelement beispielsweise um ein Halbleiterbauelement, insbesondere einen Leistungshalbleiter wie z.B. einen Leistungs-MOSFET oder ein IGBT-Bauelement.

Eine weitere Ausgestaltung der Erfindung sieht vor, dass die Metallstrukturen durch Strukturieren einer an ihrer Oberseite ebenen und an ihrer Unterseite stufigen Metallfolie hergestellt worden sind, wobei unter einer Metallfolie im Sinne der vorliegenden Erfindung jeder lötbare, metallische Leitungsträger verstanden wird, der an einer Seite plan ausgebildet ist, wobei der Begriff beispielsweise auch Metallbleche umfasst. Das Strukturieren einer solchen Metallfolie kann beispielsweise durch Ätzen, Fräsen oder Lasern erfolgen. Insofern können die im elektrischen Modul implementierten gestuften Metallstrukturen mit einem Leadframe verglichen werden, das die Kontakte des elektrischen Bauelements kontaktiert.

Auf die Herstellung der an ihrer Oberseite ebenen und an ihrer Unterseite stufigen Metallfolie wird im Hinblick auf das erfindungsgemäße Verfahren weiter unten eingegangen. Grundsätzlich kommen für die Bereitstellung der stufigen Unterseite sowohl subtraktive als auch additive Verfahren in Betracht. Ein Beispiel für ein subtraktives Verfahren ist ein sogenanntes half-etching Verfahren, bei dem nur eine Seite einer Ausgangslage oder Ausgangsfolie durch Ätzen strukturiert wird. Ein Beispiel für ein additives Verfahren ist der Aufbau der Metallfolie aus Kupferlagen. So sieht eine Ausgestaltung der Erfindung vor, dass die Metallstrukturen jeweils aus einer Mehrzahl von Kupferlagen bestehen, die beispielsweise über einen DCB-Prozess (DCM = "Direct Copper Bonded") stoffschlüssig miteinander verbunden sind.

Eine Ausgestaltung der Erfindung sieht vor, dass der Abstand zwischen der Oberseite des elektrischen Bauelements und der Unterseite der zugehörigen, auf der Oberseite des elektrischen Moduls ausgebildeten elektrischen Kontaktfläche größer als 250 µm, insbesondere größer als 500 µm ist, wobei der Bereich zwischen der Oberseite des elektrischen Bauelements und der Unterseite der zugehörigen elektrischen Kontaktfläche mit dem Vergussmaterial gefüllt ist. Der Bereich erhöhter Dicke der gestuften Metallstruktur erstreckt sich somit über mindestens 250 µm, insbesondere über mindestens 500 µm. Varianten hier zusehen vor, dass der genannte Abstand dabei kleiner als 1000 µm ist. Durch die Bereitstellung eines relativ großen Abstandes von mindestens 250 µm zwischen der Oberseite des elektrischen Bauelements und den elektrischen Kontaktflächen wird sichergestellt, dass das Vergussmaterial zuverlässig und blasenfrei vergossen werden kann.

Es wird darauf hingewiesen, dass das Substrat bzw. Vergussmaterial, in dem der keramische Schaltungsträger und das elektrische Bauelement angeordnet sind, die Außenabmessungen des elektrischen Moduls definiert. Das elektrische Modul ist beispielsweise quaderförmig ausgebildet.

In einem weiteren Erfindungsaspekt betrifft die vorliegende Erfindung ein Verfahren zur Herstellung eines elektrischen Moduls. Das Verfahren umfasst die Schritte:
- Herstellen im Nutzen einer Mehrzahl von elektrischen Einheiten, die einen keramischen Schaltungsträger und ein auf dem keramischen Schaltungsträger angeordnetes elektrisches Bauelement aufweisen, wobei die elektrischen Bauelemente an ihrer Oberseite elektrische Kontakte aufweisen,
- Bereitstellen einer an ihrer Oberseite ebenen und an ihrer Unterseite stufigen Metallfolie, die Bereiche unterschiedlicher Dicke aufweist,
- Verbinden der Mehrzahl der elektrischen Einheiten mit der Metallfolie dahingehend, dass die elektrischen Kontakte der elektrischen Bauelemente in elektrischen Kontakt mit den Bereichen erhöhter Dicke an der Unterseite der Metallfolie gelangen,
- Vergießen der Mehrzahl der elektrischen Einheiten und der Unterseite der Metallfolie mit einem Vergussmaterial, wobei die Oberseite der Metallfolie nicht mit vergossen wird,
- Strukturieren der Oberseite der Metallfolie zur Bildung von gestuften Metallstrukturen mit elektrischen Kontaktflächen auf der Oberseite, und
- Vereinzeln der vergossenen elektrischen Einheiten und zugeordneten elektrischen Kontaktflächen zur Bereitstellung einer Mehrzahl elektrischer Module.

Das erfindungsgemäße Verfahren beruht auf dem Gedanken, eine Herstellung im Nutzen vorzunehmen und dabei eine an ihrer Oberseite ebene und an ihrer Unterseite stufige Metallfolie zur Kontaktierung der elektrischen Kontakte der elektrischen Bauelemente vorzusehen und diese nach erfolgter Kontaktierung zu strukturieren, um die einzelnen gestuften Metallstrukturen bereitzustellen. Die an ihrer Unterseite gestufte Metallfolie ragt dabei in ihren Bereichen erhöhter Dicke bis zur Oberseite des jeweiligen elektrischen Moduls und kontaktiert dessen elektrischen Oberseitenkontakte.

Eine Ausgestaltung des Verfahrens sieht vor, dass das Bereitstellen der an ihrer Oberseite ebenen und an ihrer Unterseite stufigen Metallfolie die Durchführung mindestens eines subtraktiven Verfahrens an der Unterseite einer planen Ausgangs-Metallfolie umfasst. Ein Beispiel für ein subtraktives Verfahren ist ein Ätzen der Unterseite einer planen Ausgangs-Metallfolie. Ein solches einseitiges Ätzen wird auch als "Half-etching" bezeichnet. Bei einem "Half-etching" Verfahren werden Strukturen nicht durch die Metallfolie durch geätzt, sondern halb geätzt, so dass eine Strukturierung entsteht, die einseitig ist und keine Löcher in der Metallfolie bildet.

Eine weitere Ausgestaltung des Verfahrens sieht vor, dass das Bereitstellen der an ihrer Oberseite ebenen und an ihrer Unterseite stufigen Metallfolie die Herstellung der Metallfolie mittels additiver Verfahren umfasst. Ein Beispiel für ein additives Verfahren ist das Aufeinanderstapeln vorgeätzter Kupferschichten und deren stoffschlüssigen Verbindung z.B. in einem DCB-Prozess, wobei abhängig von der Dicke der Metallfolie eine unterschiedliche Anzahl von Kupferschichten gestapelt wird.

Eine weitere Ausgestaltung sieht vor, dass beim Verbinden der Mehrzahl der elektrischen Einheiten mit der Metallfolie des Weiteren eine auf dem keramischen Schaltungsträger angeordnete obere Metallisierungsschicht oder ein darauf angeordneter Abstandhalter mit einem weiteren Bereich erhöhter Dicke an der Unterseite der Metallfolie in elektrischen Kontakt gebracht wird. Auf diese Weise kann auch die Metallisierungsschicht, auf der sich das jeweilige elektrische Bauelement befindet und über die das Unterseitenpotential des elektrischen Bauelements bereitgestellt wird, über die Metallfolie kontaktiert werden, ohne dass es des Einsatzes eines zusätzlichen Abstandhalters bedarf. Alternativ wird ein solcher Abstandhalter eingesetzt.

Dabei kann vorgesehen sein, dass die an ihrer Oberseite ebene und an ihrer Unterseite stufige Metallfolie derart strukturiert ist, dass der Bereich erhöhter Dicke, der die obere Metallisierungsschicht kontaktiert, eine größere Dicke aufweist als Bereiche erhöhter Dicke, die die elektrischen Kontakte der elektrischen Bauelemente kontaktieren. Diese Ausgestaltung berücksichtigt, dass die erste Metallisierungsschicht tiefer im elektrischen Modul angeordnet ist als die Oberseite des elektrischen Bauelements.

Es wird darauf hingewiesen, dass als Metallfolie im Sinne der vorliegenden Erfindung jeder lötbare, metallische Leitungsträger verstanden wird, wobei der Begriff beispielsweise auch Metallbleche mit umfasst. In Ausführungsbeispielen handelt es sich bei der Metallfolie um eine Metallfolie aus einem Metall, einer Metalllegierung oder aus Metallmatrix-Verbundwerkstoff. Dabei können alle konventionellen Metalle aus der Leistungselektronik eingesetzt werden, zum Beispiel Kupfer und Silber. Auch können im Hinblick auf ihren Wärmeausdehnungskoeffizienten angepasste Legierungen eingesetzt werden (wie z.B. CuMo-Legierungen). Die Metallfolie ist dabei einem Leadframe vergleichbar. Die Metallfolie kann in Ausführungsbeispielen einseitig oder beidseitig eine zusätzliche Metallisierung aufweisen. Als zusätzliche Metallisierung können zum Beispiel ENIG Metallisierungen (ENIG = "Electroless Nickel Immersion Gold") oder Ni/Ag Metallisierungen eingesetzt werden, um die Sinter- und Lötbarkeit zu verbessern bzw. um gegen Korrosion zu schützen.

Das Vergießen mit einem Vergussmaterial erfolgt beispielsweise durch Spritzpressen oder Spritzgießen.

Die Erfindung wird nachfolgend unter Bezugnahme auf die Figuren der Zeichnung anhand mehrerer Ausführungsbeispiele näher erläutert. Es zeigen:
- Figur 1: schematisch ein Ausführungsbeispiel eines elektrischen Moduls, das einen keramischen Schaltungsträger, ein elektrisches Bauelement sowie Metallstrukturen umfasst, die Bereiche unterschiedlicher Dicke aufweisen und die zum einen elektrische Kontaktflächen des elektrischen Moduls bilden und zum anderen das elektrische Bauelement kontaktieren;
- Figur 2: das elektrische Modul der Figur 1 in einem vorausgegangenen Zustand, in dem die Metallstrukturen Bereiche einer Metallfolie darstellen, die anschließend unter Ausbildung der Metallstrukturen strukturiert wird;
- Figur 3: schematisch eine Mehrzahl elektrischer Einheiten, die jeweils einen keramischen Schaltungsträger und ein elektrisches Bauelement aufweisen, und deren Anordnung in einem Nutzen;
- Figur 4: eine Metallfolie, die an ihrer Oberseite eben und an ihrer Unterseite stufig ausgebildet ist;
- Figur 5: schematisch und beispielhaft den Aufbau der Metallfolie der Figur 4 durch eine Mehrzahl von stoffschlüssig miteinander verbundenen Kupferlagen;
- Figur 6: eine Anordnung, bei der die Mehrzahl elektrischer Einheiten gemäß der Figur 3 mit einer Metallfolie gemäß der Figur 4 verbunden und mit einem Vergussmaterial vergossen worden ist, anhand einer Querschnittsdarstellung einer der Einheiten;
- Figur 7: die Anordnung der elektrischen Einheiten gemäß der Figur 6 im Nutzen in perspektivischer Ansicht;
- Figur 8: die Anordnung gemäß der Figur 6 nach einer Strukturierung der Metallfolie;
- Figur 9: ein nicht gemäß der vorliegenden Erfindung ausgebildetes elektrisches Modul, das einen keramischen Schaltungsträger und ein elektrisches Bauelement umfasst;
- Figur 10: einen Ausschnitt des elektrischen Moduls der Figur 9, der einen an die Oberseite des elektrischen Bauelements angrenzenden Bereich darstellt; und
- Figur 11: ein Ablaufdiagramm der Verfahrensschritte eines Verfahrens zur Herstellung eines elektrischen Moduls gemäß der Figur 1.

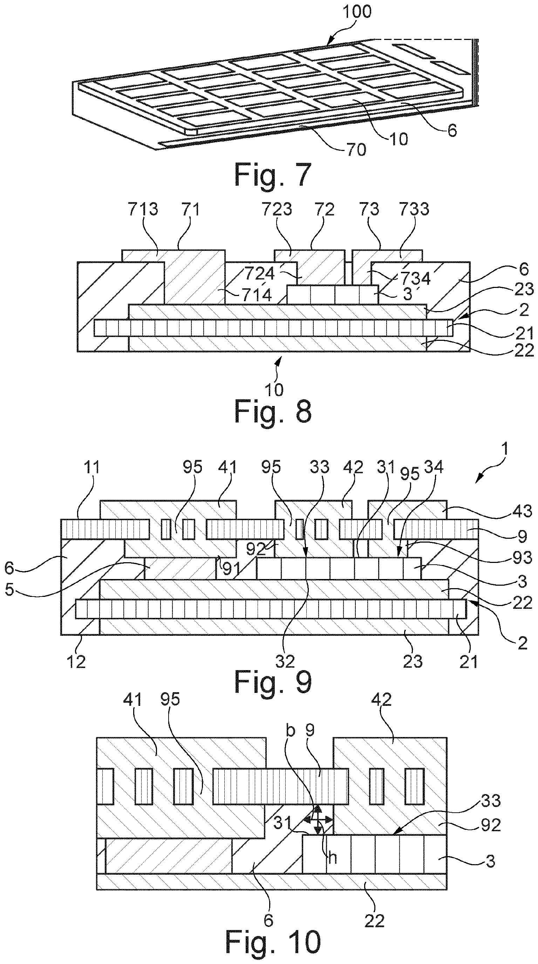

Zum besseren Verständnis des Hintergrunds der vorliegenden Erfindung wird zunächst ein nicht gemäß der Erfindung ausgebildetes elektrisches Modul anhand der Figuren 9 und 10 erläutert.

Die Figur 9 zeigt ein elektrisches Modul 1, das dazu vorgesehen ist, an der Unterseite einer nicht dargestellten Leiterplatte angeordnet zu werden. Das elektrische Modul 1 wird auch als Prepackage-Modul bezeichnet und stellt ein elektrisch isoliertes Subsystem dar. Das elektrische Modul 1 weist einen keramischen Schaltungsträger 2 und ein auf diesem angeordnetes elektrisches Bauelement 3 auf. Es umfasst eine Oberseite 11 und eine Unterseite 12, die zueinander parallel verlaufen. Das elektrische Modul 1 ist mit seiner Oberseite 11 an der Unterseite einer Leiterplatte (nicht dargestellt) angeordnet. Die Kontaktierung des elektrischen Moduls 1 erfolgt über an der Oberseite 11 ausgebildete Kontaktflächen 41, 42, 43, die über Lotverbindungen mit entsprechenden Kontaktflächen auf der Unterseite der Leiterplatte verbunden sind.

Der keramischen Schaltungsträger 2 umfasst eine isolierende Keramikschicht 21, eine auf der Oberseite der Keramikschicht 21 angeordnete erste Metallisierungsschicht 22 und eine auf der Unterseite der Keramikschicht 21 angeordnete zweite Metallisierungsschicht 23. Die Keramikschicht 21 besteht beispielsweise aus Aluminiumnitrid (AIN) oder Siliziumnitrid (Si3N4). Die Metallisierungsschichten 22, 23 bestehen beispielsweise aus Kupfer, Aluminium, Silber oder Wolfram.

Auf der ersten Metallisierungsschicht 22 ist beispielsweise über eine Lotschicht (nicht gesondert dargestellt) das elektrisches Bauelement 3 angeordnet. Das Bauelement 3 weist dabei eine Unterseite 32, mit der es auf der Metallisierungsschicht 22 angeordnet ist, und eine Oberseite 31 auf. Die Oberseite 31 und die Unterseite 32 können metallisiert, zum Beispiel verkupfert sein. Dabei bildet die Oberseite 31 des elektrischen Bauelements 3 zwei elektrische Oberseitenkontakte 33, 34 aus, die schematisch dargestellt sind. Bei dem elektrischen Bauelement 3 handelt es sich beispielsweise um einen Leistungshalbleiter wie zum Beispiel einen Leistungs-MOSFET oder ein IGBT-Bauelement, der als Chip ausgebildet ist.

Auf der ersten Metallisierungsschicht 22 ist des Weiteren ein elektrisch leitendes Abstandselement 5 angeordnet, das die gleiche Höhe wie das elektrische Bauelement 3 aufweist.

Die an der Oberseite 11 ausgebildeten Modulkontakte 41-43 sind auf einem Trägersubstrat 9 angeordnet, das beispielsweise aus einem Leiterplattenmaterial oder einem keramischen Substrat besteht. Das Trägersubstrat 9 ist über Lotschichten oder Sinterschichten 91-93 auf das elektrische Bauelement 3 bzw. den Abstandhalter 5 aufgelötet oder aufgesintert, wobei über die Lotschichten bzw. Sinterschichten 92, 93 die elektrischen Kontakte 33, 34 auf der Oberseite 31 des elektrischen Bauelements 3 kontaktiert werden. Zur elektrischen Verbindung der Modulkontakte 41-43 mit den Lotschichten bzw. Sinterschichten 92, 93 weist das Trägersubstrat 9 eine Mehrzahl von Durchkontaktierungen 95 auf. Dabei kann zur Kontaktierung des elektrischen Bauelements 3 und zur Kontaktierung der ersten Metallisierungsschicht 22 eine größere Anzahl an Durchkontaktierungen vorgesehen sein, die hintereinander angeordnet und in der Schnittdarstellung der Figur 9 daher nicht erkennbar sind.

Dabei ist vorgesehen, dass über die elektrischen Kontaktflächen 41-43, die Durchkontaktierungen 95 und die Lotschichten bzw. Sinterschichten 92, 93 die erste Metallisierungsschicht 22 mit einem Drain-Potential beaufschlagt wird und die elektrischen Kontakte 33, 34 des elektrischen Bauelements 3 mit einem Source-Potential und einem Gate-Potential beaufschlagt werden. Das Unterseitenpotential des elektrischen Bauelements 3 wird dabei über die Metallisierungsschicht 22 bereitgestellt.

Der keramische Schaltungsträger 2 und das elektrische Bauelement 3 sind in einem Substrat angeordnet, das durch ein Vergussmaterial 6 gebildet ist. Das Vergießen des keramischen Schaltungsträgers 2 und des elektrischen Bauelements 3 mit dem Vergussmaterial 6 erfolgt beispielsweise durch Spritzgießen oder Spritzpressen (sogenanntes Transfermolding). Das Vergussmaterial 6 dient der elektrischen Isolierung zwischen den spannungsbeaufschlagten Flächen im elektrischen Modul 1 und definiert die Außenabmessungen des elektrischen Moduls 1.

Der keramische Schaltungsträger 2 ist typischerweise mit seiner an der Unterseite der Keramikschicht 21 angeordneten Metallisierungsschicht 23 über ein Wärmeleitmaterial mit einem Kühlkörper (nicht dargestellt) verbunden. Der keramische Schaltungsträger 2 mit der Keramikschicht 21 dient der elektrischen Isolation des auf dem keramischen Schaltungsträger 2 angeordneten elektrischen Bauelements 3 zum Kühlkörper und stellt gleichzeitig eine thermische Anbindung zum Kühlkörper bereit. Über den Kühlkörper 6 wird dabei Verlustwärme des elektrischen Bauelements 3 abgeführt.

Bei dem Modulaufbau gemäß der Figur 9 verhält es sich so, dass der Bereich zwischen dem elektrischen Bauelement 3 und der Unterseite des Trägersubstrats 9 im Hinblick auf Isolationsanforderungen besonders kritisch ist. Dies ist anhand der Figur 10 erläutert. Die kritische Stelle aus Sicht der Isolationsanforderungen stellt die Oberseite 31 des elektrischen Bauelements 3 bzw. des Chips dar. So liegt das Unterseitenpotential des elektrischen Bauelements 3, das über die erste Metallisierungsschicht 22 bereitgestellt wird, auch am oberen Chiprand an, da der Chiprand lediglich einen hochohmigen Widerstand darstellt.

Dies bedeutet, dass das Vergussmaterial 6 die horizontale Luftstrecke b zwischen dem Chiprand und dem angrenzenden Kontakt 92 sowie die vertikale Luftstrecke h zwischen dem Chiprand bzw. der Oberseite 31 zum Trägersubstrat 9 isolieren muss, siehe Figur 10. Entsprechendes gilt für den Kontakt 34 des elektrischen Bauelements 3. Damit das Vergussmaterial zuverlässig und blasenfrei in den Spalt zwischen dem Chiprand und Trägersubstrat 9 appliziert werden kann, sind Spalthöhen von über 500 µm anzustreben. Für ein Trägersubstrat 9, das aus Leiterplattenmaterial (FR4) besteht, stellt dies eine Herausforderung dar, da typischerweise Metallisierungsschichtdicken auf der Oberseite der Leiterplatten nur bis zu 220 µm Dicke hergestellt werden können. Sofern das Trägersubstrat 9 aus einem keramischen Material besteht, sind zwar deutlich dickere Metallisierungsschichten denkbar (bis zu 800 µm), allerdings ergeben sich bei dickeren Schichtdicken sehr breite Ätzbreiten. Diese verringern einerseits die Spalthöhe und führen dazu, dass die Kontaktflächen am Chip sehr klein werden.

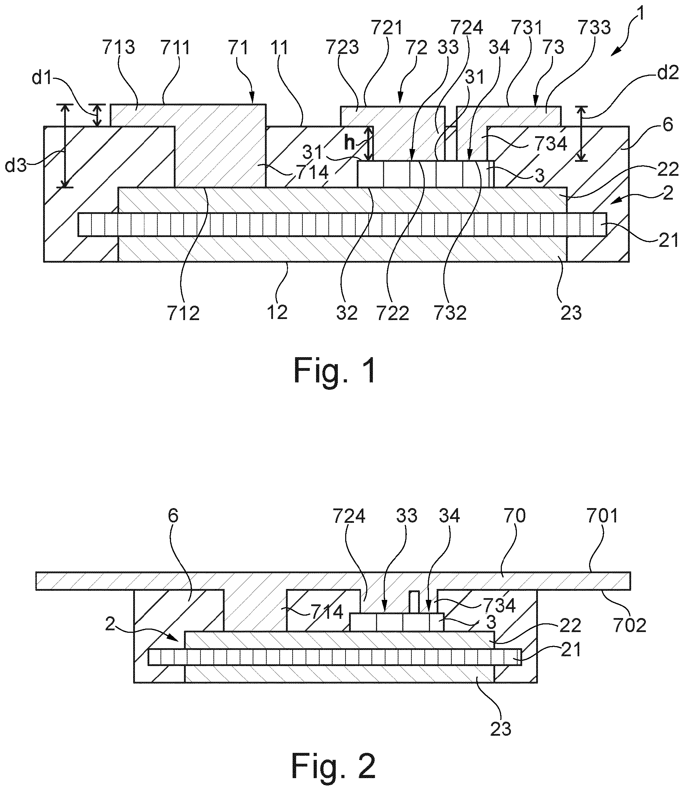

Die Figur 1 zeigt ein Ausführungsbeispiel eines erfindungsgemäßen elektrischen Moduls 1. Dieses unterscheidet sich von dem Modul der Figuren 9 und 10 im Hinblick auf die Ausbildung der Oberflächenkontakte und die Kontaktierung des elektrischen Bauelements 3 und der Metallisierungsschicht 22. Hinsichtlich des Aufbaus des Moduls 1 mit einem keramischen Schaltungsträger 2 und einem darauf angeordneten elektrischen Bauelement 3, die mit einem Vergussmaterial 6 vergossen sind, bestehen dagegen keine Unterschiede und wird insofern auf der Beschreibung der Figuren 9 und 10 verwiesen.

Das elektrische Modul 1 umfasst drei gestufte Metallstrukturen 71, 72, 73, die an der Oberseite 11 des elektrischen Moduls 1 angeordnet sind. Die Metallstrukturen 71, 72, 73 zeichnen sich dadurch aus, dass sie Bereiche unterschiedlicher Dicke aufweisen. So bildet die Metallstruktur 71 an ihrer Oberseite 711 eine elektrische Kontaktfläche 713 des elektrischen Moduls 1 aus, die eine Dicke d1 aufweist. Weiter bildet die Metallstruktur 71 einen Bereich 714 erhöhte Dicke d3 aus, der seiner Oberseite einen Teil der elektrischen Kontaktfläche 713 bildet und der an seiner Unterseite 714 die erste Metallisierungsschicht 22 des keramischen Schaltungsträgers 2 kontaktiert. Die Metallstruktur 71 ist somit gestuft und weist seitlich aneinander angrenzende Bereiche 713, 714 unterschiedlicher Dicke d1, d3 auf.

Entsprechendes gilt für die Metallstrukturen 72, 73. So bildet die Metallstruktur 72 an ihrer Oberseite 721 eine elektrische Kontaktfläche 723 aus und kontaktiert sie an ihrer Unterseite 722 in einem Bereich 724 erhöhte Dicke d2 den einen elektrischen Kontakt 33 des elektrischen Bauelements 3. Die Metallstruktur 73 bildet an ihrer Oberseite 731 eine elektrische Kontaktfläche 733 aus und kontaktiert an ihrer Unterseite 732 in einem Bereich 734 erhöhter Dicke d2 den anderen elektrischen Kontakt 34 des elektrischen Bauelements 3. Die Dicke d2 ist dabei um die Dicke des elektrischen Bauelements 3 kleiner als die Dicke d3.

Über die oberseitigen elektrischen Kontaktflächen 713, 723, 733 wird das elektrische Modul 1 elektrisch kontaktiert, wozu die Kontaktflächen 713, 723, 733 über Lotverbindungen mit zugeordneten Kontaktflächen auf einer Leiterplatte elektrisch verbunden sind. Über die elektrischen Kontaktflächen 713, 723, 733 und die Bereiche 714, 724, 734 erhöhter Dicke werden die erste Metallisierungsschicht 22 (und damit der Unterseitenkontakt des elektrischen Bauelements 3) mit einem Drain-Potential beaufschlagt und die oberseitigen elektrischen Kontakte 33, 34 des elektrischen Bauelements 3 mit einem Source-Potential und einem Gate-Potential beaufschlagt.

Es wird darauf hingewiesen, dass in alternativen Ausgestaltungen die Metallstruktur 71 die gleiche Höhe d2 aufweist wie die beiden Metallstrukturen 72, 73. Für diesen Fall ist es erforderlich, dass analog zur Figur 9 zwischen der Metallisierungsschicht 22 und der Metallstruktur 71 ein Abstandselement 5 angeordnet ist.

Das Vergussmaterial 6 erstreckt sich um die Bereiche 714, 724, 734 erhöhter Dicke. An der Oberseite 11 des elektrischen Moduls liegen jedoch naturgemäß die elektrischen Kontaktflächen 713, 723, 733 frei und sind nicht mit Vergussmaterial bedeckt. Ebenso ist auf der Unterseite 12 des elektrischen Moduls 1 die zweite Metallisierungsschicht 23 nicht mit Vergussmaterial 6 bedeckt, wobei über die zweite Metallisierungsschicht 23 eine thermische Anbindung an einen Kühlkörper erfolgt, gegebenenfalls mit einer Zwischenlage eines thermischen Schnittstellenmaterials.

Aufgrund der prinzipiellen Freiheit, die Dicke d2 der Bereiche 724, 734 der Metallstrukturen 72, 73 ohne herstellungstechnische Beschränkungen frei festzulegen, ist es möglich, den vertikalen Abstand h zwischen der Oberseite 31 des elektrischen Bauelements 3 und der Unterseite der zugehörigen elektrischen Kontaktfläche 723, 733 ausreichend groß zu wählen, so dass die erforderlichen Luft- und Kriechstreckenanforderungen eingehalten werden. Beispielsweise ist der Abstand h größer als 250 µm oder größer als 500 µm. Der Bereich zwischen der Oberseite 31 des elektrischen Bauelements 3 bis zur Unterseite der jeweiligen elektrischen Kontaktfläche 723, 733 ist dabei mit dem Vergussmaterial 6 gefüllt. Auch ist es durch solche Festlegung der Dicke d2 möglich sicherzustellen, dass das Vergussmaterial 6 zuverlässig und blasenfrei in den Spalt zwischen der Oberseite 31 des elektrischen Bauelements 3 und der Unterseite des zugeordneten elektrischen Kontaktfläche 723, 733 eingebracht werden kann.

Die Figur 2 zeigt das elektrische Modul 1 der Figur 1 in einem vorangegangenen Verfahrensschritt, bei dem die Metallstrukturen 71-73 noch nicht in vereinzelter Form vorliegen, sondern Bestandteile einer Metallfolie 70 sind, die an ihrer Oberseite 701 eben und an ihrer Unterseite 702 stufig ausgebildet ist, wobei die stufigen Bereiche die Bereiche 714, 724, 734 sind, die nach einer Strukturierung der Metallfolie 70 die Bereiche erhöhter Dicke der einzelnen Metallstrukturen 71-73 bilden. Die Strukturierung der Metallfolie 70 kann durch additive Verfahren oder subtraktive Verfahren erfolgen. Die Metallfolie 70 besteht in Ausführungsbeispielen aus einem Metall oder einer Metalllegierung wie zum Beispiel Kupfer oder Silber oder einer Kupferlegierung oder einer Silberlegierung, oder in anderen Ausführungsbeispielen aus Metallmatrix-Verbundwerkstoffen oder Graphit.

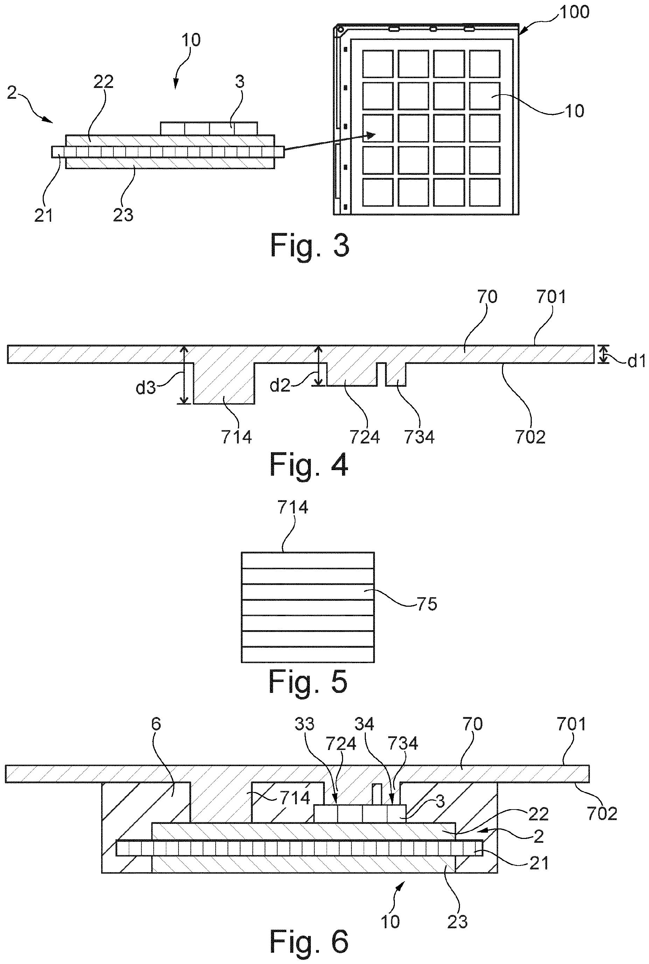

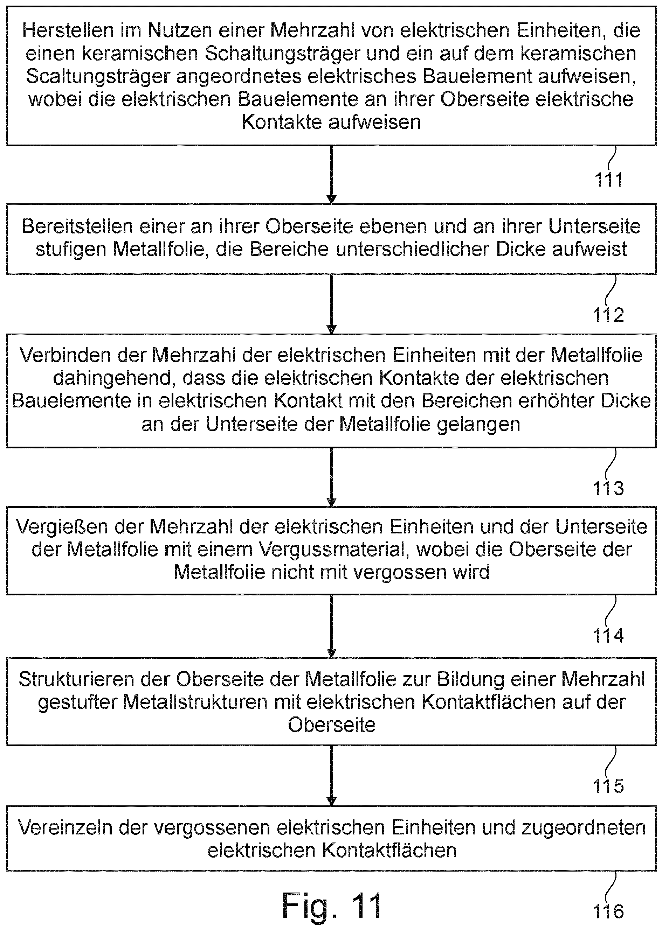

Das entsprechende Verfahren wird nachfolgend unter Bezugnahme auf die Figur 11 in Verbindung mit den Figuren 3-8 im Einzelnen erläutert.

Gemäß Schritt 111 der Figur 11 werden zunächst im Nutzen eine Mehrzahl von elektrischen Einheiten 10 hergestellt, die einen keramischen Schaltungsträger 2 und ein auf dem keramischen Schaltungsträger 2 angeordnetes elektrisches Bauelement 3 aufweisen, wobei die elektrischen Bauelemente 3 entsprechend der Figur 1 an ihrer Oberseite elektrische Kontakte aufweisen. Derartige elektrische Einheiten 10, die noch nicht das fertige Modul darstellen, sind in der Figur 3 dargestellt. Die Figur 3 zeigt ebenfalls die Anordnung solcher elektrische Einheiten 10 in einem Nutzen 100, der eine Vielzahl solcher Einheiten 10 aufweist.

Gemäß Schritt 112 der Figur 11 wird des Weiteren eine an ihrer Oberseite 701 ebene und an ihrer Unterseite 702 stufige Metallfolie 70 bereitgestellt, die Bereiche 714, 724, 734 unterschiedlicher Dicke d1, d2, d3 aufweist. Eine solche Metallfolie 70 zeigt die Figur 4, wobei die Metallfolie 70 der Figur 4 der Metallfolie 70 der Figur 2 entspricht. In Unteraspekten des Verfahrens besteht eine Vielzahl von Möglichkeiten, eine derartige, einseitig strukturierte Metallfolie 70 herzustellen.

So sieht eine Ausführungsvariante im Hinblick auf das Verfahren zur Herstellung einer solchen Metallfolie 70 vor, dass die Metallfolie 70 durch ein subtraktives Verfahren an der Unterseite 702 einer (nicht dargestellten) beidseitig planen Ausgangs-Metallfolie hergestellt wird. Ein solches subtraktives Verfahren ist beispielsweise ein Ätzen der Unterseite einer solchen Ausgangs-Metallfolie. Insbesondere sind sogenannte "Half-etching" oder "stepetching" Verfahren bekannt, bei denen mittels mehrstufiger Ätzverfahren nur eine Seite eines Ausgangsmaterials strukturiert und zu Stufen geätzt wird. Auf diese Weise kann die Metallfolie 70 mit unterschiedlicher Materialstärken bzw. unterschiedlichen Dicken d1, d2, d3 hergestellt werden.

Eine weitere Ausführungsvariante sieht im Hinblick auf das Verfahren zur Herstellung der einseitig gestuften Metallfolie 70 vor, dass die Metallfolie 70 durch additive Verfahren hergestellt wird. Beispielsweise werden vorgeätzte Kupferschichten aufeinander gestapelt und stoffschlüssig miteinander verbunden, beispielsweise in einem DCB-Prozess. Über die Anzahl der Käuferschichten kann dabei in einfacher Weise die Dicke bzw. Materialstärke der einzelnen Bereiche der Metallfolie 70 eingestellt werden. Einen solchen Aufbau der Metallfolie 70 zeigt beispielhaft und schematisch die Figur 5, bei der der Bereich 714 erhöhter Dicke der Metallfolie 70 durch aufeinander gestapelte und stoffschlüssig verbundene Kupferschichten 75 gebildet ist.

Zurückkommend auf die Figur 11 werden gemäß Schritt 113 die Mehrzahl der elektrischen Einheiten 10 mit der Metallfolie 70 dahingehend verbunden, dass die elektrischen Kontakte 73, 74 (siehe Figur 1) der elektrischen Bauelemente 3 in elektrischen Kontakt mit den Bereichen 724, 734 erhöhter Dicke d2 an der Unterseite 702 der Metallfolie 70 gelangen. Weiter gelangt die Metallisierungsschicht 22 in elektrischen Kontakt mit dem Bereich 714 erhöhter Dicke d3. Dazu kann vorgesehen sein, dass die elektrischen Einheiten 10 gemäß der Figur 3 auf die Unterseite 702 der Metallfolie 70 gesintert oder gelötet werden. Dies erfolgt ebenfalls im Nutzen.

Alternativ weist der Bereich 714 die gleiche Dicke d2 wie die Bereiche 724, 734 auf. Für diesen Fall ist auf der ersten Metallisierungsschicht 22 der elektrischen Einheiten 10 jeweils zusätzlich ein Abstandselement entsprechend dem Abstandselement 5 der Figur 9 angeordnet.

Anschließend wird in Schritt 114 die Mehrzahl der mit der Unterseite 702 der Metallfolie 70 verbundenen elektrischen Einheiten 10 mit einem Vergussmaterial 6 vergossen, wobei die Oberseite 701 der Metallfolie 70 nicht mit vergossen wird. Dies zeigt für eine elektrische Einheit 10 die Figur 6, die identisch mit der Figur 2 ist, so dass insofern auf die Erläuterungen zur Figur 2 verwiesen wird. Die Figur 7 zeigt die mit dem Vergussmaterial 6 vergossenen und mit der einen Seite der Metallfolie 70 verbundenen elektrischen Einheiten 10 im Nutzen 100. Das Vergießen mit dem Vergussmaterial 6 erfolgt beispielsweise über Spritzgießen oder Spritzpressen.

Gemäß Schritt 115 wird die Oberseite 701 der Metallfolie 70 strukturiert, um eine Mehrzahl gestufter Metallstrukturen entsprechend den Metallstrukturen 71-73 der Figur 1 zu erhalten, wobei die gestuften Metallstrukturen jeweils an der Oberseite eine elektrische Kontaktfläche ausbilden. Den entsprechenden Schritt verdeutlicht für eine elektrische Einheit 10 die Figur 8, die bis auf dem Umstand, dass noch keine Vereinzelung vorliegt, der Figur 1 entspricht, so dass auf die Ausführungen zur Figur 1 Bezug genommen wird.

Das Strukturieren der Oberseite 701 der Metallfolie 70 zur Vereinzelung der Metallstrukturen 71-73 erfolgt beispielsweise durch Atzen, Fräsen oder Lasern.

Das beschriebene Verfahren umfasst somit zwei Strukturierungsschritte. Zum einen wird eine Ausgangs-Metallfolie einseitig strukturiert, um eine einseitig gestufte Metallfolie 70 gemäß der Figur 3 zu erzeugen. Dies kann durch additive oder subtraktive Verfahren erfolgen. Zum anderen wird die Oberseite 701 der einseitig gestuften Metallfolie 70 zur Vereinzelung der Metallstrukturen 71-73 strukturiert.

Gemäß Schritt 116 werden die vergossenen elektrischen Einheiten 10 mit den inzwischen vereinzelten Metallstrukturen 71-73 und den dabei entstandenen elektrischen Kontaktflächen 713, 723, 733 abschließend vereinzelt, wobei eine Mehrzahl elektrischer Module 1 gemäß der Figur 1 entsteht.

Es versteht sich, dass die Erfindung nicht auf die oben beschriebenen Ausführungsformen beschränkt ist und verschiedene Modifikationen und Verbesserungen vorgenommen werden können, ohne von den hier beschriebenen Konzepten abzuweichen. Weiter wird darauf hingewiesen, dass beliebige der beschriebenen Merkmale separat oder in Kombination mit beliebigen anderen Merkmalen eingesetzt werden können, sofern sie sich nicht gegenseitig ausschließen. Die Offenbarung dehnt sich auf alle Kombinationen und Unterkombinationen eines oder mehrerer Merkmale aus, die hier beschrieben werden und umfasst diese. Sofern Bereiche definiert sind, so umfassen diese sämtliche Werte innerhalb dieser Bereiche sowie sämtliche Teilbereiche, die in einen Bereich fallen.

## Patentansprüche

1. Elektrisches Modul (1), das aufweist:
- einen keramischen Schaltungsträger (2),
- ein elektrisches Bauelement (3), das eine Oberseite (31) und eine Unterseite (32) umfasst, wobei das elektrische Bauelement (3) mit seiner Unterseite (32) auf dem keramischen Schaltungsträger (2) angeordnet ist und auf seiner Oberseite (31) elektrische Kontakte (33, 34) ausbildet,
- ein Substrat, in dem der keramische Schaltungsträger (2) und das elektrische Bauelement (3) angeordnet sind, wobei das Substrat durch ein Vergussmaterial (6) gebildet ist, und
- eine Oberseite (11) des elektrischen Moduls (1), die elektrische Kontaktflächen (713, 723, 733) ausbildet,
**dadurch gekennzeichnet,**
**dass** das elektrische Modul (1) gestufte Metallstrukturen (72, 73) umfasst, die an der Oberseite (11) des elektrischen Moduls (1) angeordnet sind, wobei jede Metallstruktur (72, 73) Bereiche (723, 724; 733, 734) unterschiedlicher Dicke (d1, d2) aufweist, und wobei die Metallstrukturen (72, 73)
- an ihrer Oberseite (721, 731) jeweils eine der elektrischen Kontaktflächen (723, 733) des elektrischen Moduls (1) ausbilden, und
- an ihrer Unterseite (722, 732) in einem Bereich (724, 734) erhöhter Dicke jeweils einen der elektrischen Kontakte (33, 34) auf der Oberseite (31) des elektrischen Bauelements (3) kontaktieren.

2. Modul nach Anspruch 1, **dadurch gekennzeichnet, dass** der keramische Schaltungsträger (2) eine isolierende Keramikschicht (21) und eine auf der Oberseite der Keramikschicht (21) angeordnete erste Metallisierungsschicht (22) aufweist, wobei das elektrische Bauelement (3) auf der Oberseite der ersten Metallisierungsschicht (22) angeordnet und elektrisch mit dieser verbunden ist, und
das elektrische Modul (1) eine weitere gestufte Metallstruktur (71) aufweist, die an ihrer Oberseite (711) eine der elektrischen Kontaktflächen (713) des elektrischen Moduls (1) ausbildet und die an ihrer Unterseite (712) in einem Bereich (714) erhöhter Dicke die erste Metallisierungsschicht (22) des keramischen Schaltungsträgers (2) oder einen auf dieser angeordneten Abstandhalter (5) kontaktiert.

3. Modul nach Anspruch 2, **dadurch gekennzeichnet,** das die weitere gestufte Metallstruktur (71) die erste Metallisierungsschicht (22) direkt kontaktiert und dazu einen Bereich (714) erhöhter Dicke (d3) aufweist, der höher ausgebildet ist als der Bereich (724, 734) erhöhter Dicke (d2) der anderen Metallstrukturen (72, 73).

4. Modul nach Anspruch 2 oder 3, **dadurch gekennzeichnet,** das das elektrische Modul (1) insgesamt drei Metallstrukturen (71-73) umfasst, die drei elektrische Kontaktflächen (713, 723, 733) des elektrischen Moduls (1) ausbilden, wobei zwei der Metallstrukturen (72, 73) die Oberseite (31) des elektrischen Bauelements (3) zur Bereitstellung eines Gate-Potentials und eines Source-Potentials kontaktieren und eine der Metallstrukturen (71) die erste Metallisierungsschicht (22) zur Bereitstellung eines Drain-Potentials kontaktiert.

5. Modul nach einem der vorangehenden Ansprüche, **dadurch gekennzeichnet, dass** die Metallstrukturen (71-73) durch Strukturieren einer an ihrer Oberseite (701) ebenen und an ihrer Unterseite (702) stufigen Metallfolie (70) hergestellt worden sind

6. Modul nach einem der vorangehenden Ansprüche, **dadurch gekennzeichnet, dass** die Metallstrukturen (71-73) jeweils aus einer Mehrzahl von Kupferlagen (75) bestehen, die stoffschlüssig miteinander verbunden sind.

7. Modul nach einem der vorangehenden Ansprüche, **dadurch gekennzeichnet, dass** das elektrische Bauelement (3) ein Halbleiterbauelement, insbesondere ein Leistungshalbleiter ist.

8. Verfahren zur Herstellung eines elektrischen Moduls (1) gemäß Anspruch 1 mit den Schritten:
- Herstellen (111) im Nutzen (100) einer Mehrzahl von elektrischen Einheiten (10), die einen keramischen Schaltungsträger (2) und ein auf dem keramischen Schaltungsträger (2) angeordnetes elektrisches Bauelement (3) aufweisen, wobei die elektrischen Bauelemente (3) an ihrer Oberseite (31) elektrische Kontakte (33, 34) aufweisen,
- Bereitstellen (112) einer an ihrer Oberseite (701) ebenen und an ihrer Unterseite (702) stufigen Metallfolie (70), die Bereiche unterschiedlicher Dicke (d1, d2, d3) aufweist,
- Verbinden (113) der Mehrzahl der elektrischen Einheiten (10) mit der Metallfolie (70) dahingehend, dass die elektrischen Kontakte (33, 34) der elektrischen Bauelemente (3) in elektrischen Kontakt mit Bereichen (724, 734) erhöhter Dicke (d2) an der Unterseite (702) der Metallfolie (70) gelangen,
- Vergießen (114) der Mehrzahl der elektrischen Einheiten (10) und der Unterseite (702) der Metallfolie (70) mit einem Vergussmaterial (6), wobei die Oberseite (701) der Metallfolie (70) nicht mit vergossen wird,
- Strukturieren (115) der Oberseite (702) der Metallfolie (70) zur Bildung einer Mehrzahl gestufter Metallstrukturen (71-73) mit elektrischen Kontaktflächen (713, 723, 733) auf der Oberseite, und
- Vereinzeln (116) der vergossenen elektrischen Einheiten (10) und zugeordneten elektrischen Kontaktflächen (713, 723, 733) zur Bereitstellung einer Mehrzahl elektrischer Module (1).

9. Verfahren nach Anspruch 8, **dadurch gekennzeichnet, dass** das Bereitstellen (112) der an ihrer Oberseite (701) ebenen und an ihrer Unterseite (702) stufigen Metallfolie (70) die Durchführung mindestens eines subtraktiven Verfahrens an der Unterseite einer beidseitig planen Ausgangs-Metallfolie umfasst.

10. Verfahren nach Anspruch 9, **dadurch gekennzeichnet, dass** das subtraktive Verfahren ein Ätzen der Unterseite der planen Ausgangs-Metallfolie umfasst.

11. Verfahren nach Anspruch 8, **dadurch gekennzeichnet, dass** das Bereitstellen (112) der an ihrer Oberseite (701) ebenen und an ihrer Unterseite (702) stufigen Metallfolie (70) die Herstellung der Metallfolie (70) mittels additiver Verfahren umfasst.

12. Verfahren nach Anspruch 11, **dadurch gekennzeichnet, dass** das additive Verfahren das Aufeinanderstapeln vorgeätzter Kupferschichten (75) und deren stoffschlüssige Verbindung umfasst, wobei abhängig von der Dicke der Metallfolie (70) eine unterschiedliche Anzahl von Kupferschichten (75) gestapelt wird.

13. Verfahren nach einem der vorangehenden Ansprüche, **dadurch gekennzeichnet, dass** das beim Verbinden (113) der Mehrzahl der elektrischen Einheiten (10) mit der Metallfolie (70) des Weiteren eine auf dem keramischen Schaltungsträger (2) angeordnete obere Metallisierungsschicht (22) oder ein darauf angeordneter Abstandhalter (5) mit einem weiteren Bereich (714) erhöhter Dicke (d3) an der Unterseite (702) der Metallfolie (70) in elektrischen Kontakt gebracht wird.

14. Verfahren nach Anspruch 13, **dadurch gekennzeichnet, dass** die an ihrer Oberseite (701) ebene und an ihrer Unterseite (702) stufige Metallfolie (70) derart strukturiert wird, dass der Bereich (714) erhöhter Dicke (d3), der die obere Metallisierungsschicht (22) kontaktiert, eine größere Höhe aufweist als Bereiche (724, 734) erhöhter Dicke (d2), die die elektrischen Kontakte (33, 34) der elektrischen Bauelemente (3) kontaktieren.

15. Verfahren nach einem der vorangehenden Ansprüche, **dadurch gekennzeichnet, dass** als Metallfolie (70) eine Metallfolie aus einem Metall, einer Metalllegierung oder aus Metallmatrix-Verbundwerkstoffen verwendet wird.
